# EUROPEAN PATENT APPLICATION

(11) **EP 4 456 145 A1**
(43) Date of publication of application: **30.10.2024**
(21) Application number: 22910680.2
(22) Date of filing: 16.11.2022
(51) Int. Cl.: H01L 29/786, H01L 21/28

(54) **ELECTRONIC/OPTICAL DEVICE AND MANUFACTURING METHOD THEREFOR**

(30) Priority: 22.12.2021 JP 2021207760
(71) Applicant: National Institute of Advanced Industrial Science and Technology, Chiyoda-ku Tokyo 100-8921 (JP)
(72) Inventor: CHANG, Wen-Hsin, Tsukuba-shi, Ibaraki 305-8560 (JP); IRISAWA, Toshifumi, Tsukuba-shi, Ibaraki 305-8560 (JP); OKADA, Naoya, Tsukuba-shi, Ibaraki 305-8560 (JP); SAITO, Yuta, Tsukuba-shi, Ibaraki 305-8560 (JP); HATAYAMA, Shogo, Tsukuba-shi, Ibaraki 305-8560 (JP)
(74) Representative: Gille Hrabal Partnerschaftsgesellschaft mbB Patentanwälte
(86) International application number: PCT/JP2022/042493
(87) International publication number: WO 2023/119961

(57) **Abstract**

Provided are an electronic/optical device, which is reduced in contact resistance occurring between a layered material layer and a metal electrode layer, and a method of manufacturing the device. The electronic/optical device of the present invention includes a laminated structure in which an intermediate layer is arranged between a layered material layer (2) and a metal electrode layer (3). The intermediate layer is a crystal layer (4) of an intermediate layer-forming material containing: at least one of Sb and Bi; and Te. In addition, the method of manufacturing an electronic/optical device of the present invention includes: an intermediate layer-forming step of forming, on the layered material layer (2), the intermediate layer (crystal layer (4)) obtained by crystallizing an intermediate layer-forming material containing: at least one of Sb and Bi; and Te; and a metal electrode layer-forming step of forming the metal electrode layer (3) on the intermediate layer.

## Description

### Technical Field

The present invention relates to an electronic/optical device, in which an intermediate layer is arranged between a layered material layer and a metal electrode layer for reducing a contact resistance between the layers, and a method of manufacturing the device.

### Background Art

A transition metal dichalcogenide (TMDC) having a layered structure is a thin film including a transition metal and a chalcogen, and a graphene having a layered structure is a thin film including carbon. The application of those layered materials to various electronic/optical devices has been investigated. However, when a metal electrode formed mainly of, for example, titanium, chromium, nickel, palladium, or gold is arranged on a layer formed of a layered material, there occurs a problem in that a contact resistance between the electrode and the layer increases owing to the pinning of a Fermi level resulting from: a difference in energy between the work function of the metal and the electron affinity of the layered material; and metal induced gap states (MIGS), to thereby inhibit an improvement in performance as an electronic/optical device.

To cope with such problem, for example, as a method of suppressing an increase in contact resistance due to a Schottky barrier between a semiconductor TMDC and a metal to be connected thereto, there has been proposed a method including inserting a metal TMDC into an interface between the semiconductor TMDC and the metal (see Patent Document 1). In the literature, after a description that it has been known that the adoption of a specific material combination between the metal electrode and the semiconductor TMDC achieves an ohmic junction, there is a description that the insertion of the above-mentioned metal TMDC suppresses the increase in contact resistance even in a range of combinations wider than the specific material combination that has already been known.

### Prior Art Document

### Patent Document

Patent Document 1: JP 2017-79313 A

### Disclosure of the Invention

### Problems to be solved by the Invention

As described in Patent Document 1, it is desired that the increase in contact resistance between the metal electrode and the semiconductor TMDC can be suppressed in a wide range of material combinations therebetween. In addition, in the semiconductor TMDC, for example, both of n-type and p-type characteristics are obtained, and hence the application of the semiconductor TMDC to the CMOS circuit of an LSI including a complementary combination of an nFET and a pFET can be expected. Accordingly, it is also desired that a reduction in contact resistance between the metal electrode and each of the FETs of both the types can be achieved. Thus, it is required that such semiconductor device can be manufactured with ease, stability and reliability.

The present invention has been made in view of such circumstances as described above, and an object of the present invention is to provide an electronic/optical device, which is reduced in contact resistance occurring between its layered material layer and metal electrode layer, and a method of manufacturing the device.

### Means for solving the Problems

An electronic/optical device according to the present invention includes a laminated structure in which an intermediate layer is arranged between a layered material layer and a metal electrode layer, wherein the intermediate layer is a crystal layer of an intermediate layer-forming material containing: at least one selected from the group consisting of Sb and Bi; and Te.

In addition, a method of manufacturing an electronic/optical device according to the present invention includes: an intermediate layer-forming step of forming, on a layered material layer, an intermediate layer obtained by crystallizing an intermediate layer-forming material containing: at least one selected from the group consisting of Sb and Bi; and Te; and a metal electrode layer-forming step of forming a metal electrode layer on the intermediate layer.

### Advantageous Effects of the Invention

According to the present invention, the electronic/optical device, which is reduced in contact resistance occurring between a layered material layer and a metal electrode layer, and the method of manufacturing the device can be provided.

### Brief Description of the Drawings

FIGS. 1 are views for illustrating the outlines of an embodiment of the present invention.
FIG. 2(a) is a band diagram when a metal electrode layer is connected to a layered material layer, and FIG. 2(b) is a band diagram when an intermediate layer is connected thereto.
FIGS. 3 are sectional views for illustrating a manufacturing process for a top gate-type transistor according to an embodiment of the present invention.
FIGS. 4 are sectional views for illustrating the manufacturing process for the top gate-type transistor according to the embodiment of the present invention.
FIGS. 5 are sectional views for illustrating the manufacturing process for the top gate-type transistor according to the embodiment of the present invention.
FIGS. 6 are sectional views for illustrating the manufacturing process for the top gate-type transistor according to the embodiment of the present invention.
FIG. 7(a), FIG. 7(b) and FIG. 7(c) are a top sectional view, a side sectional view and a front sectional view for illustrating the configuration of a nanosheet/nanowire transistor according to an embodiment of the present invention, respectively.
FIGS. 8 are views of the band gaps of respective materials.

### Mode for carrying out the Invention

An embodiment for carrying out the present invention is described in detail below with reference to the drawings.

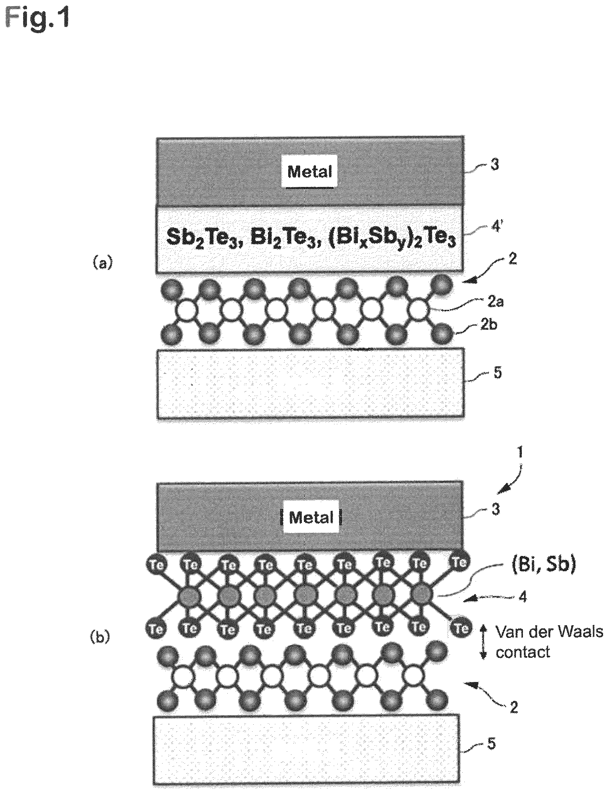

First, a method of manufacturing an electronic device and the resultant electronic device are described with reference to FIGS. 1.

As illustrated in FIG. 1(a), first, an amorphous film 4' of an intermediate layer-forming material containing: at least one selected from the group consisting of Sb and Bi; and Te is formed on a layered material layer 2. The layered material layer 2 is formed from at least one selected from the group consisting of a semiconductive transition metal dichalcogenide and a graphene. The layered material layer 2 is formed on the surface of an insulating film 5 formed of, for example, SiO₂.

Next, a metal electrode layer 3 is formed on the amorphous film 4'.

In other words, the amorphous film 4' of the intermediate layer-forming material containing: at least one selected from the group consisting of Sb and Bi; and Te is formed between the layered material layer 2 and the metal electrode layer 3.

One material for the layered material layer 2 is, for example, the semiconductive transition metal dichalcogenide. Transition metal dichalcogenides include a dichalcogenide having a property as a metal and a dichalcogenide having a property as a semiconductor, and the dichalcogenide having a property as a semiconductor is applied. The term "semiconductive" as used herein means that the dichalcogenide has a property as a semiconductor.

The semiconductive transition metal dichalcogenide is a compound of a transition metal element 2a, such as Mo, W or Pt, and a chalcogen element 2b, such as S, Se or Te. Specific examples of the semiconductive transition metal dichalcogenide may include MoS₂, MoSe₂, MoTe₂, WS₂, WSe₂, WTe₂, PtS₂, PtSe₂ and PtTe₂.

In addition, a graphene formed of C may be used as another material for the layered material layer 2. The concept of the term "graphene" as used herein includes a multilayered product of individual graphenes in addition to a monoatomic layer (single-layer) graphene, and includes layered graphenes of both a sheet shape (graphene sheet) and a tube shape (carbon nanotube).

A material for the metal electrode layer 3 is not particularly limited, and there may be used, for example, tungsten (W), cobalt (Co) and ruthenium (Ru).

Examples of the material (intermediate layer-forming material) for the amorphous film 4' include compounds represented by the following formulae: SbₓTe₁₋ₓ, BiₓTe₁₋ₓ and (BiₓSb₁₋ₓ)₂Te₃ (provided that in each of the formulae, 0≤x≤1).

Next, as illustrated in FIG. 1(b), the amorphous film 4' is crystallized by heating at a temperature equal to or more than the crystallization temperature of the material. Thus, there is obtained a laminated structure in which a crystal layer 4 (intermediate layer) of the intermediate layer-forming material containing: at least one selected from the group consisting of Sb and Bi; and Te is arranged between the layered material layer 2 and the metal electrode layer 3.

As a method of forming the metal electrode layer 3, the layer may be formed on the crystal layer 4 instead of being formed on the amorphous film 4'.

In an electronic device 1 thus obtained, a resistance value in the laminated structure of the layered material layer 2, the intermediate layer (crystal layer 4) and the metal electrode layer 3 can be made smaller than a contact resistance between the layered material layer 2 and the metal electrode layer 3 in the case where the metal electrode layer 3 is directly laminated on the layered material layer 2. In other words, the laminated structure of the layered material layer 2, the intermediate layer (crystal layer 4) and the metal electrode layer 3 can reduce the contact resistance between the layered material layer 2 and the metal electrode layer 3.

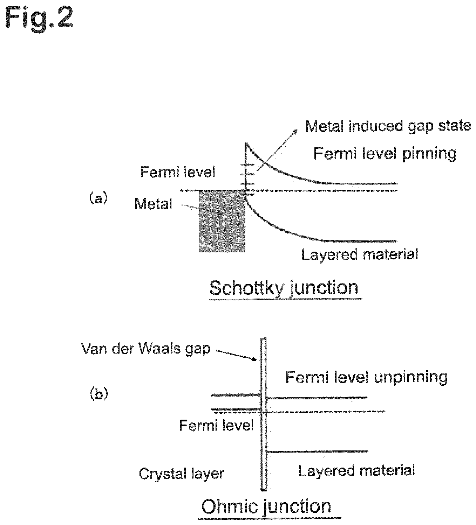

The reason for the foregoing is described with reference to FIG. 2(a) and FIG. 2(b).

First, reference is made to FIG. 2(a). In general, when a layered material layer and a metal electrode layer are joined to each other, a Schottky junction having a Schottky barrier is formed owing to the pinning of a Fermi level resulting from: a difference between the work function of the metal electrode layer and the work function of the layered material layer; and metal induced gap states (MIGS). Accordingly, the joining of the metal electrode layer to the layered material layer increases a contact resistance therebetween.

In contrast, as illustrated in FIG. 2(b), according to the structure of the electronic device 1 in this embodiment, when the intermediate layer (crystal layer 4) of the intermediate layer-forming material containing: at least one selected from the group consisting of Sb and Bi; and Te is joined to the layered material layer 2, a junction based on a van der Waals force is formed and hence a potential barrier can be prevented from occurring without occurrence of the pinning of a Fermi level. In other words, an ohmic junction can be formed to reduce the contact resistance.

Next, a manufacturing example of the electronic device 1 is described.

### <Transistor Manufacturing Example 1>

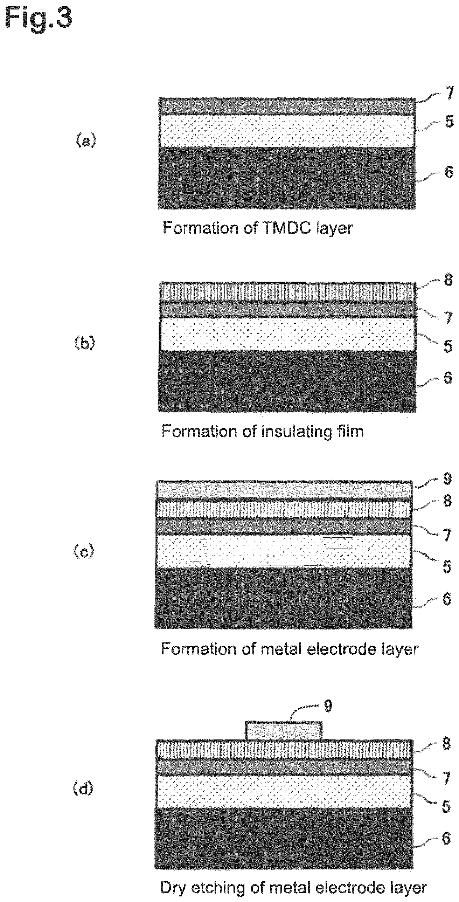

A manufacturing process for a top gate-type field effect transistor (FET) serving as an example of a semiconductor electronic device to which the above-mentioned laminated structure is applied is illustrated in FIGS. 3.

As illustrated in FIG. 3(a), first, a semiconductor TMDC layer 7 is formed on the insulating film 5 formed on a semiconductor substrate 6 by chemical vapor deposition (CVD). Then, as illustrated in FIG. 3(b), a high dielectric constant (high-x) insulating film 8 is formed on the layered material layer formed from a semiconductive transition metal dichalcogenide (hereinafter referred to as "semiconductor TMDC layer 7") by an atomic layer deposition (ALD) method. The semiconductor TMDC layer 7 is a specific example of the above-mentioned layered material layer 2, and a graphene layer may be used. Further, as illustrated in FIG. 3(c), a gate electrode layer 9 is formed on the insulating film 8. Then, as illustrated in FIG. 3(d), a gate region is patterned by lithography, followed by the dry etching of the gate electrode layer 9 to form a gate electrode.

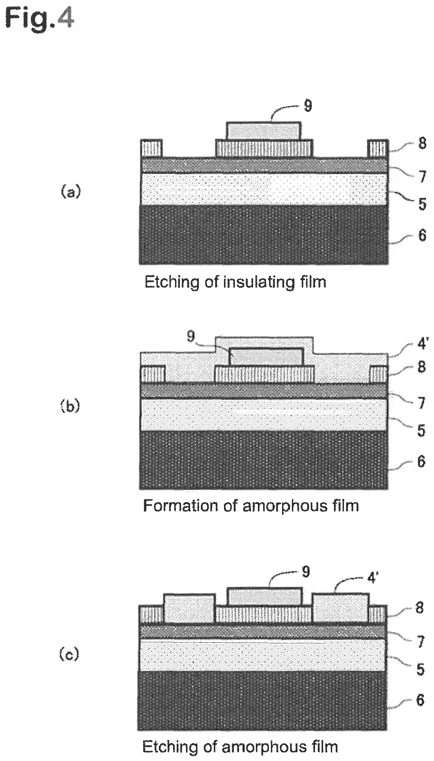

After that, as illustrated in FIG. 4(a), the insulating film 8 is etched, and as illustrated in FIG. 4(b), the amorphous film 4' formed of Sb and/or Bi and Te is deposited on the semiconductor TMDC layer 7 by, for example, a sputtering method. At this time, the thickness of the amorphous film 4' is preferably 20 nm or less. Then, as illustrated in FIG. 4(c), the amorphous film 4' except that in a source/drain region is removed by lithography and dry etching.

A material for the semiconductor substrate 6 is not particularly limited, and any substrate, such as a Si, Ge, GaAs, InP, sapphire (Al₂O₃), or glass substrate, may be used.

A material for the semiconductor TMDC layer 7 may be, for example, any one of the materials described for the layered material layer 2, and examples thereof include MoS₂, MoSe₂, MoTe₂, WS₂, WSe₂, WTe₂, PtS₂, PtSe₂ and PtTe₂. In addition, when the layer is formed as a graphene layer, for example, a single-layer or multilayer graphene sheet or a carbon nanotube may be used.

Any material may be given as a material for the insulating film 8, and there may be used oxide films of Al₂O₃, HfO₂, ZrO₂, Y₂O₃ and La₂O₃, for example.

A material for the gate electrode layer 9 is not particularly limited, and there may be used, for example, tungsten (W), titanium (Ti), nickel (Ni), aluminum (Al), platinum (Pt), gold (Au), titanium nitride (TiN) and tantalum nitride (TaN), or an alloy or a laminated film containing two or more kinds of those materials.

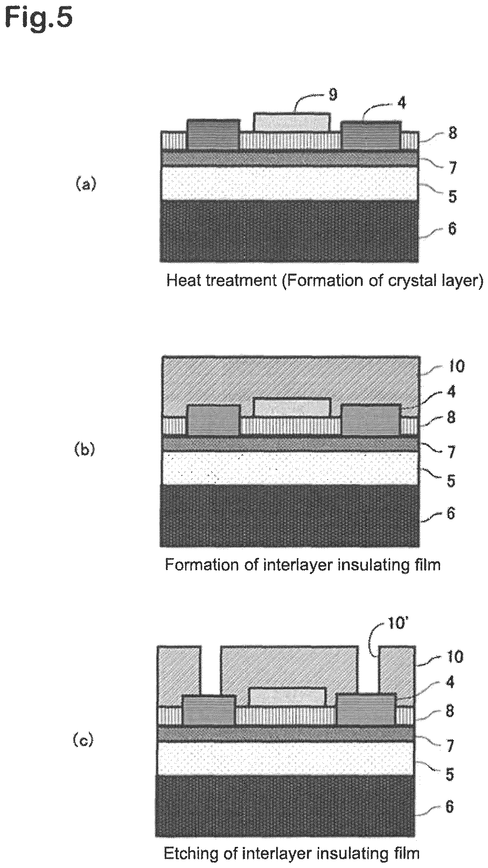

Then, as illustrated in FIG. 5(a), the amorphous film 4' is crystallized by heating at a temperature equal to or more than the crystallization temperature of its material. Thus, the crystal layer 4 (intermediate layer) is formed. After that, as illustrated in FIG. 5(b), an interlayer insulating film 10 is formed, and as illustrated in FIG. 5(c), the film is etched to form contact holes 10'.

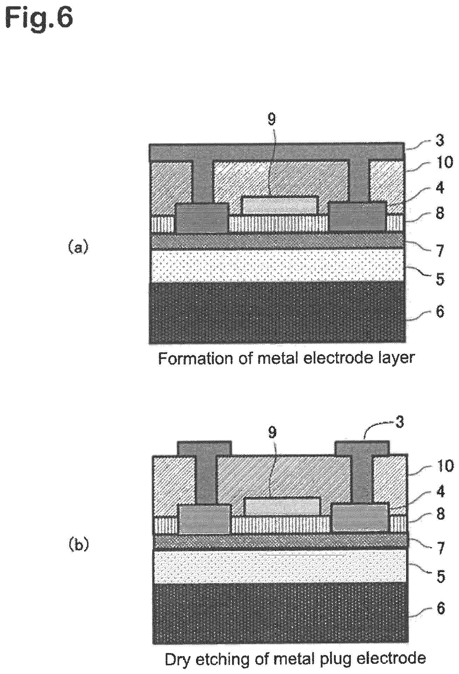

Further, as illustrated in FIG. 6(a), the metal electrode layer 3 serving as a plug electrode is formed, and as illustrated in FIG. 6(b), plug electrodes formed of the metal electrode layer 3 are formed by lithography and dry etching. Thus, the FET can be obtained as a semiconductor electronic device in which the crystal layer 4 (intermediate layer) is formed between the semiconductor TMDC layer 7 and the metal electrode layer 3.

Specifically, there is obtained a transistor structure including: the semiconductor TMDC layer 7 (the layer corresponds to the layered material layer 2 and may be a graphene layer); the gate electrode layer 9 arranged on the semiconductor TMDC layer 7 through the insulating film 8; a source electrode portion formed by laminating the crystal layer 4 (intermediate layer) and the metal electrode layer 3 in the stated order on the semiconductor TMDC layer 7; and a drain electrode portion formed by laminating the crystal layer 4 (intermediate layer) and the metal electrode layer 3 in the stated order at a position on the semiconductor TMDC layer 7 opposed to the source electrode portion across the gate electrode layer 9.

At this time, the semiconductor TMDC layer 7 and the crystal layer 4 (intermediate layer) are joined to each other by a van der Waals force. In other words, a top gate-type field effect transistor reduced in contact resistance can be obtained. A heat treatment temperature in the heating is preferably determined from, for example, the range of 100°C or more.

### <Transistor Manufacturing Example 2>

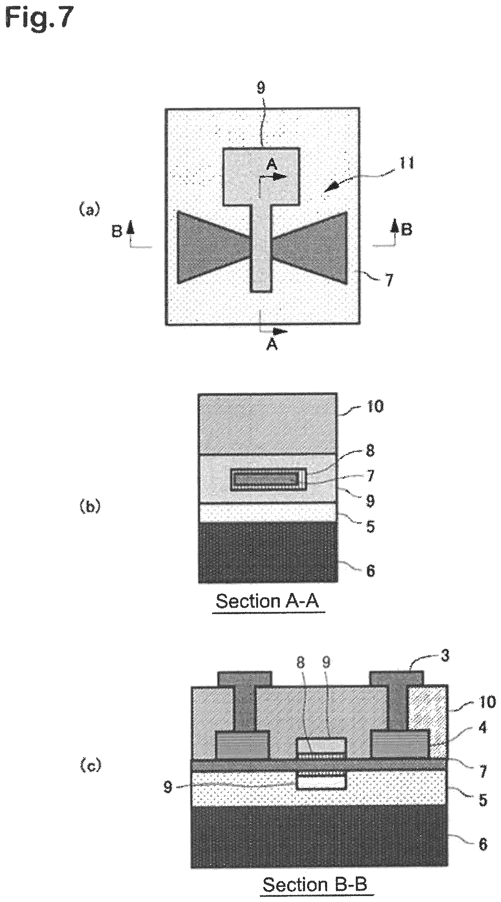

The configuration of a nanosheet/nanowire-type transistor 11 to which the above-mentioned laminated structure is applied is illustrated in FIG. 7(a). As illustrated in FIG. 7(b), the nanosheet/nanowire-type transistor 11 has, on the semiconductor TMDC layer 7 for forming a nanosheet/nanowire channel (the layer corresponds to the layered material layer 2 and may be a graphene layer), such a gate all around (GAA) structure that the insulating film 8 and the gate electrode layer 9 completely cover the top, bottom, left and right of the channel.

Specifically, there is obtained a transistor structure including: the semiconductor TMDC layer 7 (the layer corresponds to the layered material layer 2 and may be a graphene layer); the gate electrode layer 9 arranged so as to cover the top surface and bottom surface of the semiconductor TMDC layer 7 and at least two side surfaces facing each other out of the four side surfaces thereof through the insulating film 8; a source electrode portion formed by laminating the crystal layer 4 (intermediate layer) and the metal electrode layer 3 in the stated order on the top surface of the semiconductor TMDC layer 7; and a drain electrode portion formed by laminating the crystal layer 4 (intermediate layer) (different from that of the source electrode portion) and the metal electrode layer 3 in the stated order at a position on the top surface of the semiconductor TMDC layer 7 opposed to the source electrode portion across the gate electrode layer 9.

As in the top gate-type transistor of Manufacturing Example 1, in the nanosheet/nanowire-type transistor 11 of FIG. 7(c), the crystal layer 4 (intermediate layer) is arranged between the semiconductor TMDC layer 7 and the metal electrode layer 3. In other words, as in Manufacturing Example 1, a nanosheet/nanowire-type transistor reduced in contact resistance can be obtained.

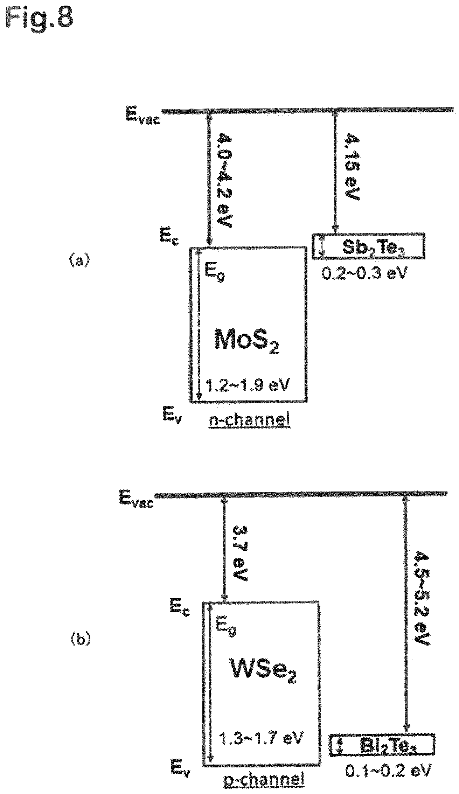

As illustrated in FIGS. 8, in the semiconductor TMDC layer 7, a band gap E_{g} is present between the highest level Eᵥ of a valence band and the lowest level E_{c} of a conduction band. According to the example of the figures, the use of the crystal layer 4 (intermediate layer) having a work function close to that of the lowest level E_{c} of the conduction band in n-channel MoS₂ is advantageous for a reduction in resistance, and Sb₂Te₃ is desirably used as the intermediate layer-forming material (see FIG. 8(a)). In addition, the use of the crystal layer 4 (intermediate layer) having a work function close to that of the highest level Eᵥ of the valence band in p-channel WSe₂ is advantageous for a reduction in resistance, and Bi₂Te₃ is desirably used as the intermediate layer-forming material (see FIG. 8(b)).

When the crystal layer 4 (intermediate layer) is arranged between the semiconductor TMDC layer 7 (the layer corresponds to the layered material layer 2 and may be a graphene layer) and the metal electrode layer 3 as described above, an increase in contact resistance between the semiconductor TMDC layer 7 and the metal electrode layer 3 is prevented. In addition, an ohmic junction can be obtained between the semiconductor TMDC layer 7 and the crystal layer 4 (intermediate layer) to reduce a contact resistance therebetween.

The following comparative test was performed: an example sample, which was a FET including the crystal layer 4 (intermediate layer), which used Sb₂Te₃ as the intermediate layer-forming material, arranged between the layered material layer 2 and the metal electrode layer 3, and a sample for comparison, which was a FET formed in the same manner except that the crystal layer 4 (intermediate layer) was not arranged, were actually manufactured; and the I_{D}-V_{D} characteristics of both the samples were compared to each other. In this comparative test, MoS₂ was used in the formation of the layered material layer 2 and Ni was used in the formation of the metal electrode layer 3.

As a result, in the example sample in which the crystal layer 4 (intermediate layer) was arranged, an increase in on-state current about five times as large as that in the sample for comparison in which the layer was not arranged was able to be obtained. In other words, the arrangement of the crystal layer 4 (intermediate layer) was able to largely reduce the contact resistance between the layers 2 and 3.

It was found that when the crystal layer 4 (intermediate layer) of the intermediate layer-forming material containing: at least one selected from the group consisting of Sb and Bi; and Te was arranged between the layered material layer 2 and the metal electrode layer 3 as described above, the contact resistance therebetween was able to be reduced.

The above-mentioned manufacturing process for the transistor is merely an example, and any other modification falls within the scope of the disclosure of the present invention. For example, the crystal layer 4 that has been crystallized may be directly formed on the layered material layer 2 formed of the semiconductor TMDC layer 7 by film formation temperature adjustment without performance of any heat treatment after the film formation (in the example of FIG. 4(b), the amorphous film 4' is directly formed as the crystal layer 4).

In addition to a single-layer TMDC, a multilayered product of TMDCs may also be used as the semiconductor TMDC layer 7.

The above-mentioned laminated structure may be applied to any electronic/optical device (electronic device or optical device) having a junction portion between a metal electrode layer and a layered material layer, such as a Schottky diode, a light-emitting diode, a solar cell, or a thermoelectric conversion element, in addition to the transistor. For example, at the time of the formation of the Schottky diode, an improvement in a rectifying characteristic can be expected by increasing a barrier through the insertion of: Bi₂Te₃ between an n-type semiconductor TMDC layer formed of, for example, MoS₂ and the metal electrode layer; or Sb₂Te₃ between a p-type semiconductor TMDC layer formed of, for example, WSe₂ and the metal electrode layer.

Although the examples according to the present invention and the modifications based thereon have been described above, the present invention is not necessarily limited to those examples. In addition, a person skilled in the art would be able to find various alternative examples and alterations without departing from the gist of the present invention or the scope of the attached claims.

### Reference Signs List

- 1: electronic device
- 2: layered material layer
- 3: metal electrode layer (plug)
- 4: crystal layer
- 4': amorphous film
- 5: insulating film
- 6: semiconductor substrate
- 7: semiconductor TMDC layer
- 8: insulating film
- 9: gate electrode layer
- 10: interlayer insulating film
- 11: nanosheet/nanowire-type transistor.

## Claims

1. An electronic/optical device, comprising a laminated structure in which an intermediate layer is arranged between a layered material layer and a metal electrode layer,
wherein the intermediate layer is a crystal layer of an intermediate layer-forming material containing: at least one selected from the group consisting of Sb and Bi; and Te.

2. The electronic/optical device according to claim 1, wherein the layered material layer is formed so as to contain at least one selected from the group consisting of a semiconductive transition metal dichalcogenide and a graphene.

3. The electronic/optical device according to claim 1, wherein the intermediate layer-forming material is at least one selected from the group consisting of SbₓTe₁₋ₓ where 0≤x≤1 and BiₓTe₁₋ₓ where 0≤x≤1.

4. The electronic/optical device according to claim 1, wherein the intermediate layer-forming material is (SbₓBi₁₋ₓ)₂Te₃ where 0≤x≤1.

5. The electronic/optical device according to claim 1, wherein the electronic/optical device comprises a transistor structure including:
the layered material layer formed so as to contain at least one selected from the group consisting of the semiconductive transition metal dichalcogenide and the graphene;
a gate electrode arranged on the layered material layer through an insulating film;
a source electrode portion formed by laminating the intermediate layer and the metal electrode layer in the stated order on the layered material layer; and
a drain electrode portion formed by laminating the intermediate layer and the metal electrode layer in the stated order at a position on the layered material layer opposed to the source electrode portion across the gate electrode.

6. The electronic/optical device according to claim 1, wherein the electronic/optical device comprises a transistor structure including:
the layered material layer formed so as to contain at least one selected from the group consisting of the semiconductive transition metal dichalcogenide and the graphene;
a gate electrode arranged so as to cover a top surface and a bottom surface of the layered material layer and at least two side surfaces facing each other out of four side surfaces thereof through an insulating film;
a source electrode portion formed by laminating the intermediate layer and the metal electrode layer in the stated order on the top surface of the layered material layer; and
a drain electrode portion formed by laminating the intermediate layer and the metal electrode layer in the stated order at a position on the top surface of the layered material layer opposed to the source electrode portion across the gate electrode.

7. A method of manufacturing an electronic/optical device, comprising:
an intermediate layer-forming step of forming, on a layered material layer, an intermediate layer obtained by crystallizing an intermediate layer-forming material containing: at least one selected from the group consisting of Sb and Bi; and Te; and
a metal electrode layer-forming step of forming a metal electrode layer on the intermediate layer.
